# EUROPEAN PATENT APPLICATION

(11) **EP 2 669 945 A1**
(43) Date of publication of application: **04.12.2013**
(21) Application number: 12008555.0
(22) Date of filing: 21.12.2012
(51) Int. Cl.: H01L 25/065, H01L 23/14

(54) **Interposer die for semiconductor packaging**

(30) Priority: 31.05.2012 US 201213484571
(71) Applicant: Broadcom Corporation, Irvine, CA 92617 (US)
(72) Inventor: Griswold, Mark, Freemont, CA 94539 (US)
(74) Representative: Jehle, Volker Armin

(57) **Abstract**

According to one exemplary implementation, a method includes lithographically forming a plurality of reticle images on a semiconductor wafer. The method further includes singulating the semiconductor wafer into an interposer die such that the interposer die includes at least a portion of a first reticle image and at least a portion of a second reticle image from the plurality of reticle images. The first reticle image and the second reticle image can be produced from a single reticle. The method can further include electrically connecting a first active die to a second active die through the interposer die. The method can also include electrically connecting the first active die to a package substrate through the interposer die.

## Description

### BACKGROUND

Integrated circuit (IC) products continue to become increasingly integrated. Increasing product integration may require an increase in the number of components of an IC product, which must be accommodated for in the IC product. One approach to manufacturing an IC product includes utilizing a single large active die to accommodate the components of the IC product. The single large active die can be attached to a package substrate. In another approach, the components of the IC product are distributed across two or more active dies, which are each smaller than the single large active die. The active dies are electrically connected to one another to form the IC product. The active dies can be arranged in a planar fashion, or can be stacked over one another.

### SUMMARY

The present disclosure is directed to an interposer die for semiconductor packaging, substantially as shown in and/or described in connection with at least one of the figures, and as set forth more completely in the claims.

### BRIEF DESCRIPTION OF THE DRAWINGS

Figure 1 shows a process flow diagram illustrating an exemplary process.
Figure 2A illustrates a block diagram including an exemplary semiconductor wafer undergoing photolithography.
Figure 2B illustrates a top view of an exemplary semiconductor wafer.
Figure 2C illustrates a top view of an exemplary interposer die.
Figure 2D illustrates a cross-sectional view of an exemplary interposer die.
Figure 2E illustrates a top view of an exemplary semiconductor arrangement.
Figure 2F illustrates a cross-sectional view of an exemplary semiconductor arrangement.
Figure 2G illustrates a cross-sectional view of an exemplary semiconductor package.

### DETAILED DESCRIPTION

The following description contains specific information pertaining to implementations in the present disclosure. The drawings in the present application and their accompanying detailed description are directed to merely exemplary implementations. Unless noted otherwise, like or corresponding elements among the figures may be indicated by like or corresponding reference numerals. Moreover, the drawings and illustrations in the present application are generally not to scale, and are not intended to correspond to actual relative dimensions.

According to one aspect of the invention, a method is provided that comprises:
lithographically forming a plurality of reticle images on a semiconductor wafer;
singulating said semiconductor wafer into an interposer die such that said interposer die includes at least a portion of a first reticle image and at least a portion of a second reticle image from said plurality of reticle images.

Advantageously, said interposer die is larger than said first reticle image.

Advantageously, said interposer die is larger than said second reticle image.

Advantageously, said first reticle image and said second reticle image are produced from a single reticle.

Advantageously, the method is further comprising electrically connecting a first active die to a second active die through said interposer die.

Advantageously, said interposer die includes said first reticle image and said second reticle image.

Advantageously, the method is further comprising electrically connecting a first active die to a package substrate through said interposer die.

According to another aspect of the invention, a semiconductor package is provided that comprises:
first and second active dies;
an interposer die comprising at least a portion of a first reticle image and at least a portion of a second reticle image;
said interposer die electrically connecting said first active die to said second active die.

Advantageously, said first reticle image and said second reticle image are produced from a single reticle.

Advantageously, said interposer die electrically connects said first active die to a package substrate.

Advantageously, said interposer die electrically connects said second active die to a package substrate.

Advantageously, said first and second active dies and said interposer die are silicon dies.

Advantageously, said first active die is electrically and mechanically connected to said at least said portion of said first reticle image and said at least said portion of said second reticle image.

Advantageously, said first active die is electrically connected to said second active die through said at least said portion of said second reticle image.

According to another aspect of the invention, a semiconductor package is provided that comprises:
an interposer die comprising a first reticle image and a second reticle image;
said interposer die electrically connecting a first active die to a second active die;
wherein said first reticle image and said second reticle image are produced from a single reticle.

Advantageously, said interposer die electrically connects said first active die to a package substrate.

Advantageously, said interposer die electrically connects said second active die to a package substrate.

Advantageously, said first and second active dies and said interposer die are silicon dies.

Advantageously, said first active die is electrically and mechanically connected to said first reticle image and said second reticle image.

Advantageously, said first active die is electrically connected to said second active die through said second reticle image.

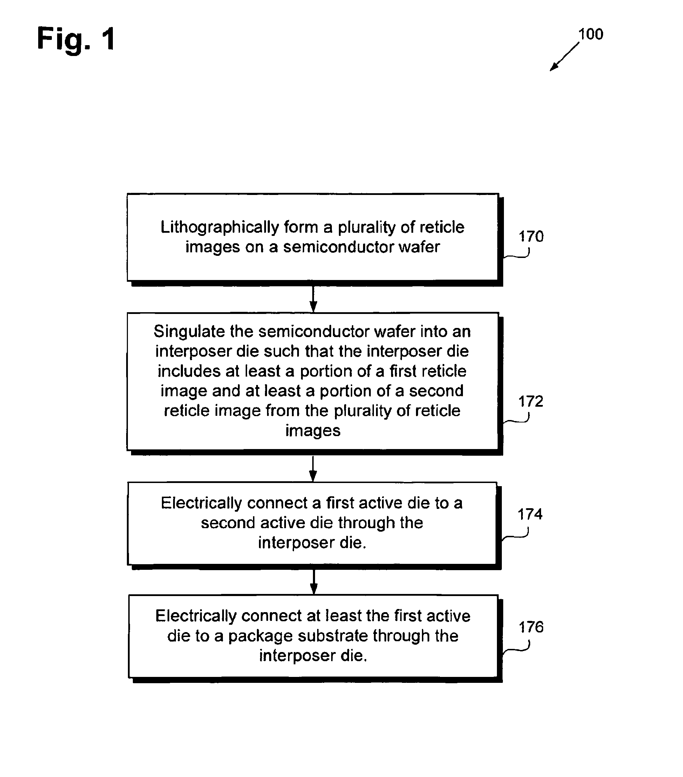

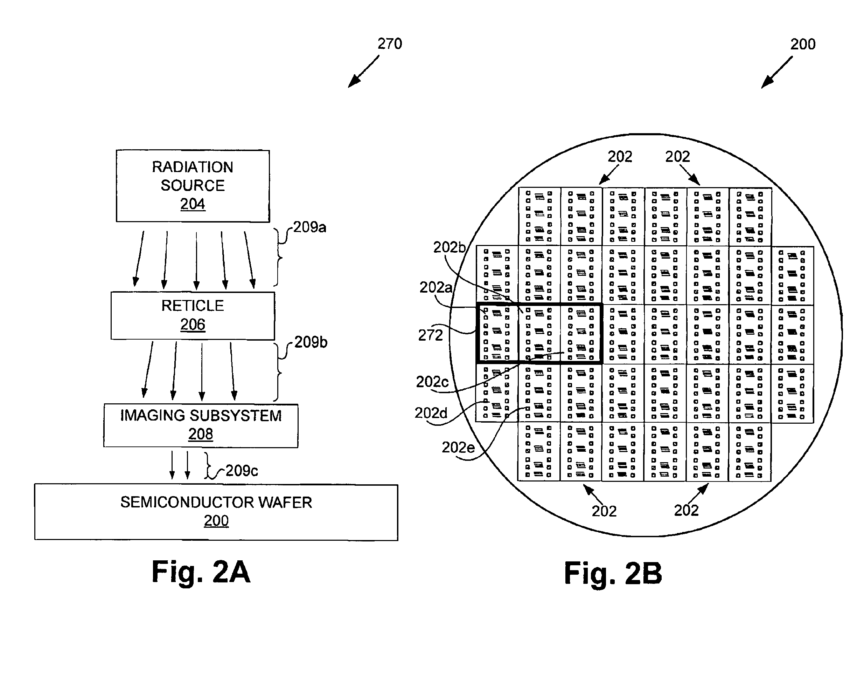

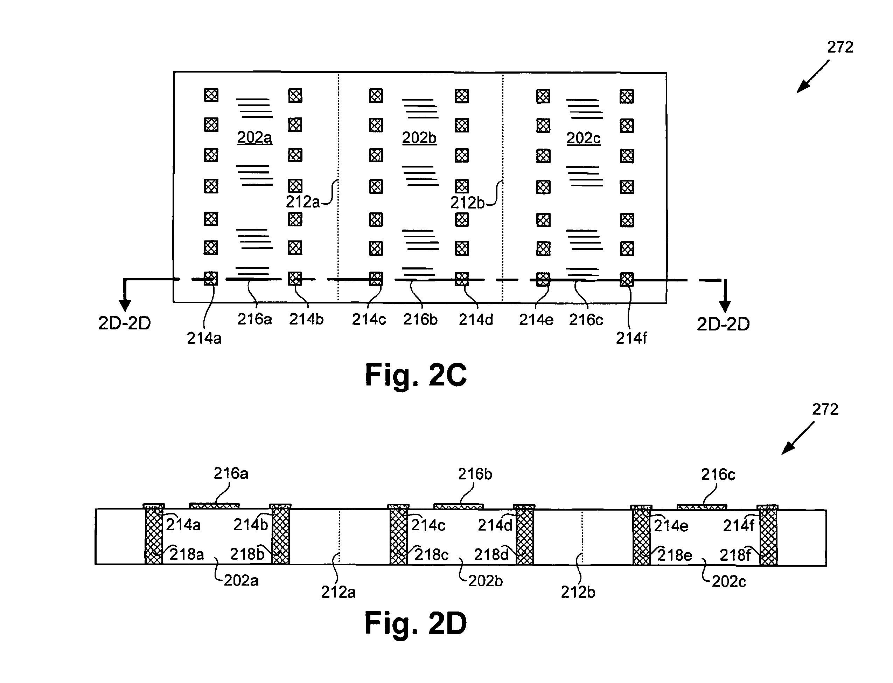

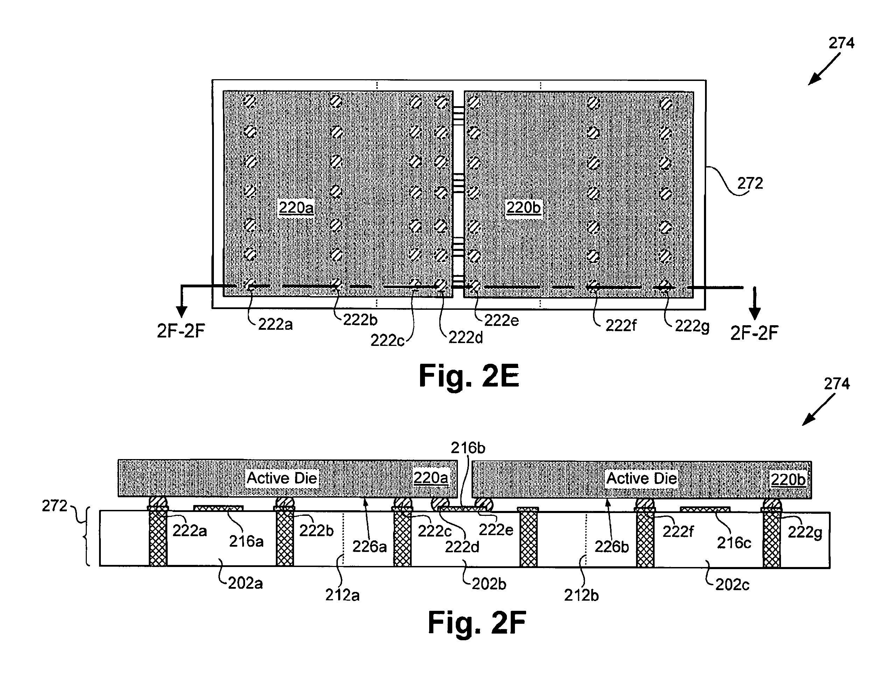

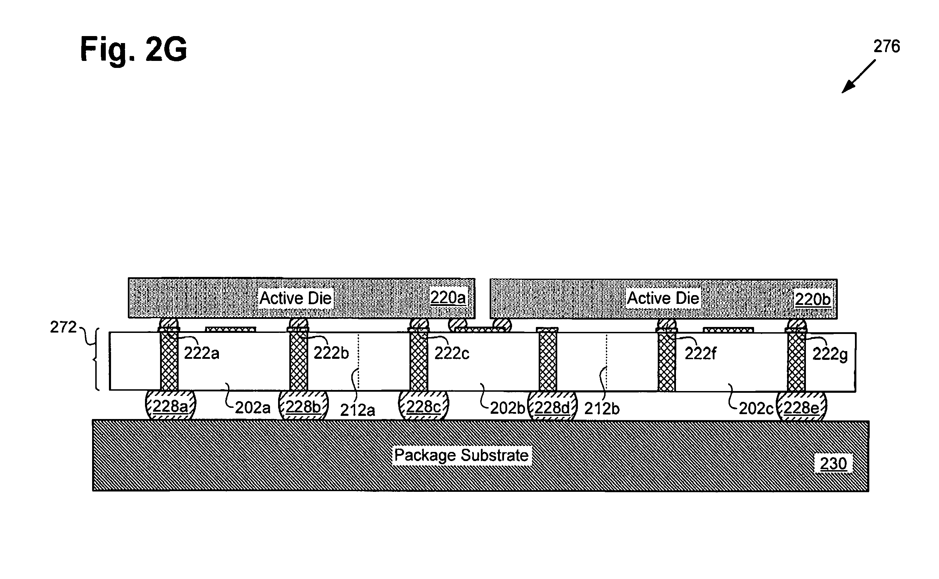

Figure 1 shows a process flow diagram illustrating a process 100. For illustrative purposes, the process 100 is described with respect to Figures 2A, 2B, 2C, 2D, 2E, 2F, and 2G. However, the process 100 is not limited by specific features shown in Figures 2A, 2B, 2C, 2D, 2E, 2F, and 2G.

Referring now to Figures 1, 2A, and 2B the process 100 includes lithographically forming a plurality of reticle images (e.g., plurality of reticle images 202) on a semiconductor wafer (e.g., semiconductor wafer 200) (170 in Figure 1).

Figure 2A illustrates a block diagram 270 including a semiconductor wafer 200 undergoing photolithography. Figure 2B illustrates a top view of the semiconductor wafer 200 after the semiconductor wafer 200 has undergone photolithography. As shown in Figure 2B, the semiconductor wafer 200 includes a plurality of reticle images 202, of which, reticle images (i.e., die images) 202a, 202b, 202c, 202d, and 202e are individually labeled in Figure 2B. Each of the plurality of reticle images 202 is adjoining at least one other of the plurality of reticle images 202. The semiconductor wafer 200 includes semiconductor material, such as silicon. As an example, in the present implementation, the semiconductor wafer 200 is a silicon wafer.

The plurality of reticle images 202 is lithographically formed on the semiconductor wafer 200. This can be achieved in various ways, one of which includes utilizing a radiation source 204, a reticle 206, and an imaging subsystem 208 to photolithographically form the plurality of reticle images 202 on the semiconductor wafer 200. The radiation source 204, the reticle 206, and the imaging subsystem 208 can utilize, as examples, step-and-repeat exposure or step-and-scan exposure, but are not limited to these technologies.

The radiation source 204, which can be a light source, is configured to direct radiation energy 209a, such as light, towards the reticle 206. The radiation energy 209a can be ultraviolet light and can have, as examples, a deep ultraviolet (DUV) wavelength or a vacuum ultraviolet (VUV) wavelength. The reticle 206 selectively blocks the radiation energy 209a such that an energy pattern 209b is defined by the reticle 206 and is transferred towards the semiconductor wafer 200. The imaging subsystem 208, which can include a stepper assembly or a scanner assembly, as examples, sequentially directs the energy pattern 209b transmitted by the reticle 206 to a series of desired locations on a photoresist on the semiconductor wafer 200. The imaging subsystem 208 can include a series of lenses and/or reflectors for use in scaling and directing the energy pattern 209b towards the semiconductor wafer 200 as an imaging (or exposure) energy pattern 209c. As a result, the semiconductor wafer 200 is exposed to the imaging energy pattern 209c. The imaging energy pattern 209c causes chemical reaction(s) in the photoresist on the semiconductor wafer 200 to form each of the plurality of reticle images 202.

In the implementation shown, the plurality of reticle images 202 is produced from a single reticle, e.g., the reticle 206. Thus, each of the plurality of reticle images 202 (e.g., the reticle image 202a and the reticle image 202b) can be formed utilizing similar imaging energy patterns (e.g., the imaging energy pattern 209c). For example, the imaging energy pattern 209c can be utilized to form the reticle image 202a and a similar imaging energy pattern can be utilized to form the reticle image 202b (and other reticle images of the plurality of reticle images 202). As such, each reticle image in the plurality of reticle images 202 has similar components, which are situated in similar arrangements. However, in other implementations, any of the plurality of reticle images 202 can be produced from a different reticle than the reticle 206. In other words, the plurality of reticle images 202 can be produced utilizing more than a single reticle. In such implementations, each reticle image in the plurality of reticle images 202 may have different components, or can have similar components that are situated in different arrangements.

Referring now to Figures 1, 2B, 2C, and 2D the process 100 includes singulating the semiconductor wafer (e.g., semiconductor wafer 200) into an interposer die (e.g., interposer die 272) such that the interposer die includes at least a portion of a first reticle image (e.g., reticle image 202a) and at least a portion of a second reticle image (e.g., reticle image 202b) from the plurality of reticle images (e.g., plurality of reticle images 202) (172 in Figure 1).

The interposer die 272, shown in Figure 2B prior to singulation, includes the reticle images 202a, 202b, and 202c. Figure 2C illustrates a top view of the interposer die 272. Figure 2D illustrates a cross-sectional view of the interposer die 272 along a cross-section 2D-2D in Figure 2C. The reticle images 202a and 202b are separated by a reticle image boundary 212a and the reticle images 202b and 202c are separated by the reticle image boundary 212b. The interposer die 272 is formed by singulating the semiconductor wafer 200, shown in Figure 2B such that the interposer die 272 includes the reticle image 202a, the reticle image 202b, and the reticle image 202c.

In the present implementation, the interposer die 272 includes substantially all of the reticle image 202a, the reticle image 202b, and the reticle image 202c. In other implementations, the interposer die 272 only includes a portion of any of the reticle images 202a, 202b, and 202c. Furthermore, while the interposer die 272 includes at least a portion of three reticle images, in other implementations, the interposer die 272 includes at least a portion of two reticle images (e.g., the reticle images 202a and 202b) or at least a portion of more than three reticle images. For example, in various implementations, the interposer die 272 can include any set or subset of the reticle images 202a, 202b, 202c, 202d, and 202e or other reticle images, shown in Figure 2B. The interposer die 272 is shown in Figure 2C as being generally rectangular, but the interposer die 272 may have various different geometries. Furthermore, the semiconductor wafer 200 is singulated to form other interposer dies, which may be similar to (e.g., substantially identical to) or different than the interposer die 272.

In the present implementation, the reticle image 202a includes a die pad 214a electrically connected to a conductive via 218a. The reticle image 202a also includes a die pad 214b electrically connected to a conductive via 218b. The reticle image 202a also includes an inter-die interconnect 216a. The reticle image 202b includes a die pad 214c electrically connected to a conductive via 218c. The reticle image 202b also includes a die pad 214d electrically connected to a conductive via 218d. The reticle image 202b also includes an inter-die interconnect 216b. The reticle image 202c includes a die pad 214e electrically connected to a conductive via 218e. The reticle image 202c also includes a die pad 214f electrically connected to a conductive via 218f. The reticle image 202c also includes an inter-die interconnect 216c.

It is noted that the die pads 214a, 214b, 214c, 214d, 214e, and 214f, the conductive vias 218a, 218b, 218c, 218d, 218e, and 218f, and the inter-die interconnects 216a, 216b, and 216c do not cross the reticle image boundaries 212a and 212b. The die pads 214a, 214b, 214c, 214d, 214e, and 214f, the conductive vias 218a, 218b, 218c, 218d, 218e, and 218f, and the inter-die interconnects 216a, 216b, and 216c include conductive material, such as copper. The conductive vias 218a, 218b, 218c, 218d, 218e, and 218f can be through semiconductor vias (TSVs), such as through silicon vias. The interposer die 272 can include additional features, such as passivation layers, metal layers, and solder bumps, which are omitted for clarity.

In some implementations, the reticle 206 has a reticle size limit depending upon fabrication requirements for the semiconductor wafer 200. For example, a stepper assembly may only accept a reticle that does not exceed a certain reticle size limit. As one specific example, many stepper assemblies impose a reticle size limit of around 20 millimeters by 32 millimeters. The reticle size limit constrains the maximum two-dimensional area of each of the plurality of reticle images 202, shown in Figure 2B. By singulating the semiconductor wafer 200, such that the interposer die 272 includes at least a potion of the reticle image 202a and at least a portion of the reticle image 202b, the interposer die 272 can be larger than the reticle size limit. For example, the interposer die 272 is larger than the reticle image 202a and is also larger than the reticle image 202b, which each may have been produced at the reticle size limit. As such, the interposer die 272 can accommodate additional active die area and/or active dies. In this way, the interposer die 272 may be utilized to increase product integration for IC products.

Referring now to Figures 1, 2E, and 2F the process 100 includes electrically connecting a first active die (e.g., active die 220a) to a second active die (e.g., active die 220b) through the interposer die (e.g., interposer die 272) (174 in Figure 1).

Figure 2E illustrates a top view of a semiconductor arrangement 274. Figure 2F illustrates a cross-sectional view of the semiconductor arrangement 274 along a cross-section 2F-2F in Figure 2E. The semiconductor arrangement includes an active die 220a and an active die 220b situated over the interposer die 272. The active die 220a and the active die 220b each include semiconductor material, such as silicon. For example, the active die 220a and the active die 220b are each silicon dies in the present implementation. Thus, in the present implementation, the active dies 220a and 220b and the interposer die 272 are silicon dies. By forming the active dies 220a and 220b and the interposer die 272 from materials having substantially the same or similar thermal expansion coefficients, electrical connections between the active dies 220a and 220b and the interposer die 272 can be made smaller due to reduced thermo-mechanical stress.

The active die 220a can be substantially identical to the active die 220b, or can be different. In the present example, the active die 220a includes microbumps (or more generally output terminals), such as microbumps 222a, 222b, 222c, and 222b that are situated on a bottom surface 226a thereof. Similarly, the active die 220b includes microbumps 222e, 222f, and 222g situated on a bottom surface 226b thereof. The microbumps 222a, 222b, 222c, 222d, 222e, 222f, and 222g (also referred to as "microbumps 222") are indicated in Figure 2E utilizing dashed lines, but would otherwise not be visible in Figure 2E.

The active die 220a is electrically connected to the active die 220b through the interposer die 272 (e.g., through the reticle image 202b). As shown in Figure 2F, the active die 220a is electrically connected to the active die 220b through at least the microbump 222d, the inter-die interconnect 216b of the interposer die 272, and the microbump 222e. As such, the active die 220a and the active die 220b can form a highly integrated IC product. In the present implementation, the reticle images 202a, 202b, and 202c are produced from a single reticle, e.g., the reticle 206. As such, certain components in at least one of the reticle images 202a, 202b, and 202c might not be utilized. For example, neither of the active dies 220a and 220b are connected to the inter-die interconnect 216a and the inter-die interconnect 216c. However, the reticle 206 produces these components so as to provide the inter-die interconnect 216b to electrically connect the active dies 220a and 220b. Similarly, neither of the active dies 220a and 220b are connected to the die pad 214d.

In the implementation shown, the active die 220a is electrically and mechanically connected to the reticle image 202a and the reticle image 202b. As the active die 220a is situated over the reticle image 202a and the reticle image 202b, the active die 220a can provide electrical connection across the reticle image boundary 212a. Similarly, the active die 220b is electrically and mechanically connected to the reticle image 202b and the reticle image 202c. As the active die 220b is situated over the reticle image 202b and the reticle image 202c, the active die 220c can provide electrical connection across the reticle image boundary 212b. In some implementations, the active die 220b can be situated over only the reticle image 202b, or both the reticle image 202a and the reticle image 202b. One such implementation is where the interposer die 272 does not include the reticle image 202c. Furthermore, additional active dies, passive dies, and/or other components can be included in the semiconductor arrangement 274. In some implementations, one or more additional active dies are stacked over and electrically connected to the active die 220a and/or the active die 220b.

Referring now to Figures 1 and 2G the process 100 includes electrically connecting at least the first active die (e.g., active die 220a) to a package substrate (e.g., package substrate 230) through the interposer die (e.g., interposer die 272) (176 in Figure 1).

Figure 2G illustrates a cross-sectional view of a semiconductor package 276. In the semiconductor package 276, the active die 220a is electrically connected to a package substrate 230 through the interposer die 272. The active die 220b is also electrically connected to the package substrate 230 through the interposer die 272. As shown in Figure 2G, solder balls 228a, 228b, 228c, 228d, and 228e (also referred to as solder balls 228) can optionally be utilized to electrically and mechanically connect the interposer die 272 to the package substrate 230. The solder balls 228 can be attached to the interposer die 272 before or after the interposer die 272 is singulated from the semiconductor wafer 200 (e.g., the interposer die 272 in Figures 2C and 2D can include the solder balls 228). The semiconductor package 276 can be situated over and electrically connected to a printed circuit board (PCB) or other substrate to provide electrical connection to the active dies 220a and 220b.

It is noted that in some implementations, the semiconductor package 276 may not include the package substrate 230. For example, the solder balls 228 may be utilized for electrical connection to the active dies 220a and 220b of the semiconductor package 276. Furthermore, the semiconductor package 276 can include other components, such as molding that are not shown in Figure 2G for clarity.

From the above description it is manifest that various techniques can be used for implementing the concepts described in the present application without departing from the scope of those concepts. Moreover, while the concepts have been described with specific reference to certain implementations, a person of ordinary skill in the art would recognize that changes can be made in form and detail without departing from the scope of those concepts. As such, the described implementations are to be considered in all respects as illustrative and not restrictive. It should also be understood that the present application is not limited to the particular implementations described above, but many rearrangements, modifications, and substitutions are possible without departing from the scope of the present disclosure.

## Claims

1. A method comprising:
lithographically forming a plurality of reticle images on a semiconductor wafer;
singulating said semiconductor wafer into an interposer die such that said interposer die includes at least a portion of a first reticle image and at least a portion of a second reticle image from said plurality of reticle images.

2. The method of claim 1, wherein said interposer die is larger than said first reticle image.

3. The method of claim 1, wherein said interposer die is larger than said second reticle image.

4. The method of claim 1, wherein said first reticle image and said second reticle image are produced from a single reticle.

5. The method of claim 1 comprising electrically connecting a first active die to a second active die through said interposer die.

6. A semiconductor package comprising:
first and second active dies;
an interposer die comprising at least a portion of a first reticle image and at least a portion of a second reticle image;
said interposer die electrically connecting said first active die to said second active die.

7. The semiconductor package of claim 6, wherein said first reticle image and said second reticle image are produced from a single reticle.

8. The semiconductor package of claim 6, wherein said interposer die electrically connects said first active die to a package substrate.

9. The semiconductor package of claim 6, wherein said interposer die electrically connects said second active die to a package substrate.

10. The semiconductor package of claim 6, wherein said first and second active dies and said interposer die are silicon dies.

11. A semiconductor package comprising:
an interposer die comprising a first reticle image and a second reticle image;
said interposer die electrically connecting a first active die to a second active die;
wherein said first reticle image and said second reticle image are produced from a single reticle.

12. The semiconductor package of claim 11, wherein said interposer die electrically connects said first active die to a package substrate.

13. The semiconductor package of claim 11, wherein said interposer die electrically connects said second active die to a package substrate.

14. The semiconductor package of claim 11, wherein said first and second active dies and said interposer die are silicon dies.

15. The semiconductor package of claim 11, wherein said first active die is electrically and mechanically connected to said first reticle image and said second reticle image.
